# EUROPEAN PATENT APPLICATION

(11) **EP 4 811 341 A1**
(43) Date of publication of application: **23.09.2026**
(21) Application number: 26165959.3
(22) Date of filing: 19.03.2026
(51) Int. Cl.: G09G 3/34, G09G 3/36

(54) **DISPLAY DEVICE AND DRIVING METHOD THEREOF**

(30) Priority: 19.03.2025 US 202563774111 P
(71) Applicant: E Ink Holdings Inc., 30078 Hsinchu (TW)
(72) Inventor: CHANG, Chun Kai, Hsinchu (TW); CHEN, Wei-Tsung, Hsinchu (TW); WU, Chi-Liang, Hsinchu (TW)
(74) Representative: Becker, Eberhard

(57) **Abstract**

A display device and a driving method thereof are provided. The display device includes a pixel array (110) and a data driver circuit (130). The data driver circuit is coupled to pixel data lines in the pixel array. The data driver circuit includes a data driver chip (210) and a data multiplexer (220). The data multiplexer includes multiplexer circuits (221-i). Each multiplexer circuit includes a first transistor (T1, T4), a bootstrap capacitor (Cbsti), a diode (T2, T5), and a second transistor (T3, T6). The first transistor is coupled to one pixel data line (Data_IN_Di) and one chip data line (DATA_IC_Di). The bootstrap capacitor is coupled between a second terminal and the control terminal of the first transistor. The diode is coupled between the control terminal of the first transistor and a first control line. The data multiplexer may be combined with gate bootstrap circuits or pixel voltage bootstrap circuits to form a system-level low-voltage driving solution.

## Description

### BACKGROUND

### Technical Field

The disclosure relates to a display technology, and particularly relates to a display device and a driving method thereof.

### Description of Related Art

Compared to other display technologies (such as LED, OLED), electronic paper related display technologies require stronger electric fields to drive display units (such as microcapsules, cholesteric liquid crystals, etc.) to perform accurate and rapid displacement. The pixel circuit or driving system needs to be able to provide higher data signals (data voltages) to corresponding terminals to generate the required electric field.

The data driver circuit of existing display technology may include a data driver chip (data driver IC) and a data multiplexer. The data multiplexer is used to output the data signal provided from the data driver chip as double or multiple data lines to enter the pixel array, so as to reduce the number of pins of the data driver chip. When the data multiplexer transmits a data signal (data voltage), the signal (voltage) on the control terminal in the data multiplexer needs to be greater than the data voltage to write the data signal into the pixel circuit to drive the display unit. In other words, the data multiplexer may need to be equipped with a high voltage driving system to boost the voltage of its control terminal, resulting in increased system cost.

### SUMMARY

The disclosure provides a display device and a driving method thereof, having good display driving capability.

The display device of the present invention includes a pixel array and a data driver circuit. The pixel array includes a plurality of pixel data lines. The data driver circuit is coupled to the pixel data lines. The data driver circuit includes a data driver chip and a data multiplexer. The data driver chip includes a plurality of chip data lines. The data multiplexer includes a plurality of multiplexer circuits. Each of the multiplexer circuits includes a first transistor, a bootstrap capacitor, a diode, and a second transistor. A first terminal of the first transistor is coupled to one of the pixel data lines. A second terminal of the first transistor is coupled to one of the chip data lines. The bootstrap capacitor is coupled between the second terminal of the first transistor and a control terminal of the first transistor. The diode is coupled between the control terminal of the first transistor and a first control line. A first terminal of the second transistor is coupled to a reference voltage terminal, a second terminal of the second transistor is coupled to the control terminal of the first transistor, and a control terminal of the second transistor is coupled to a second control line.

The present invention provides a driving method for a display device. The display device includes a pixel array and a data driver circuit. The pixel array includes a plurality of pixel data lines. The data driver circuit includes a data driver chip and a plurality of multiplexer circuits. The data driver chip includes a plurality of chip data lines. Each of the multiplexer circuits includes a first transistor, a bootstrap capacitor, a diode, and a second transistor. A first terminal of the first transistor is coupled to one of the pixel data lines. A second terminal of the first transistor is coupled to one of the chip data lines. The bootstrap capacitor is coupled between the second terminal of the first transistor and a control terminal of the first transistor. The diode is coupled between the control terminal of the first transistor and a first control line. A first terminal of the second transistor is coupled to a reference voltage terminal. A second terminal of the second transistor is coupled to the control terminal of the first transistor. A control terminal of the second transistor is coupled to a second control line. A first control signal is transmitted through the first control line and a second control signal is transmitted through the second control line. The driving method includes: in a first time period, the first control signal is boosted from a low voltage level to a high voltage level, the diode is in a conduction state, so that a first voltage at the control terminal of the first transistor is boosted from the low voltage level to the high voltage level; in a second time period after the first time period, the first control signal drops from the high voltage level to the low voltage level, the diode is in a turn-off state, and the first voltage is maintained at the high voltage level; in a third time period after the second time period, the one of the chip data lines provides a first data voltage, and the first voltage is boosted from the high voltage level by the first data voltage based on the bootstrap capacitor; and, at a fourth time point after the third time period, the second control signal is boosted from the low voltage level to the high voltage level, the second transistor is in a conduction state, and the first voltage is the same as a reference voltage at the reference voltage terminal based on the second transistor.

Based on the above, the display device and driving method thereof according to embodiments of the present invention additionally provide two transistors and a bootstrap capacitor in each multiplexer circuit in the data multiplexer, and enable the working voltage at the control terminal of the first transistor in the multiplexer circuit to be effectively boosted to a sufficiently high level (for example, up to positive 68 volts at maximum), thereby ensuring that data signals with a voltage range of positive and negative 24 volts can be smoothly and accurately transmitted to each pixel unit in the pixel array. Based on the bootstrap capacitor and voltage bootstrap technology in the data multiplexer, the demand for high-voltage processes can be significantly reduced, without the need to be equipped with high-voltage drive systems (such as boosters), thereby reducing manufacturing costs.

Based on the above, the display device and driving method thereof according to each embodiment of the present invention enables the working voltage at the control terminal of the first transistor (e.g., VMG1) in each multiplexer circuit of the data multiplexer to be effectively boosted to a sufficiently high level (for example, up to positive 68 volts at maximum) through a bootstrap capacitor (e.g., Cbst1) disposed within the multiplexer circuit, thereby ensuring that data signals with a voltage range of positive and negative 24 volts may be smoothly and accurately written to pixel units in the pixel array. The bootstrap capacitor and voltage bootstrap technology of the data multiplexer eliminate the need for a high-voltage external booster and reduce system cost and complexity.

### BRIEF DESCRIPTION OF THE DRAWINGS

Aspects of the present disclosure are best understood from the following detailed description when read with the accompanying figures. It is noted that, in accordance with the standard practice in the industry, various features are not drawn to scale. In fact, the dimensions of the various features may be arbitrarily increased or reduced for clarity of discussion.
FIG. 1 is a schematic diagram of a display device according to an embodiment of the present invention.
FIG. 2 is a block schematic diagram of a pixel array and a data driver circuit according to an embodiment of the present invention.
FIG. 3 is a timing diagram of multiple signals and voltages in the data multiplexer of FIG. 2.
FIG. 4 is a flowchart of a driving method of a display device according to an embodiment of the present invention.

### DESCRIPTION OF THE EMBODIMENTS

In order to make the content of the present invention more easily understood, the following specific embodiments are provided as examples that the present invention can indeed be implemented accordingly. In addition, wherever possible, components/members/steps using the same reference numerals in the drawings and embodiments represent the same or similar parts.

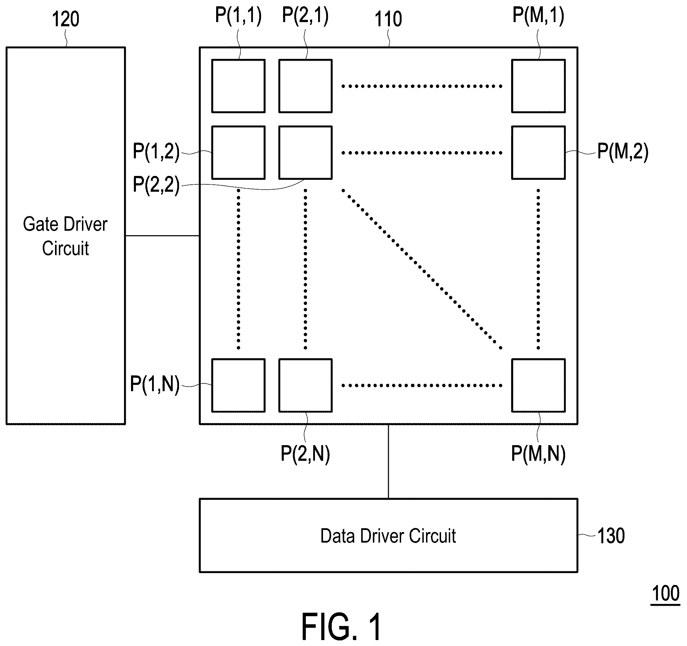

FIG. 1 is a schematic diagram of a display device according to an embodiment of the present invention. Referring to FIG. 1, the display device 100 includes a pixel array 110, a gate driver circuit 120, and a data driver circuit 130 (also referred to as a source driver circuit). The pixel array 110 is coupled to the gate driver circuit 120 and the data driver circuit 130. The pixel array 110 includes a plurality of pixel units P(1,1)~P(M,N), where M and N are positive integers. The gate driver circuit 120 may be coupled to the pixel units P(1,1)~P(M,N) through a plurality of gate signal lines. The data driver circuit 130 may be coupled to the pixel units P(1,1)~P(M,N) through a plurality of data signal lines (also referred to as source signal lines). Those applying this embodiment may operate the gate driver circuit 120 and the data driver circuit 130 independently according to their requirements, or may integrate the gate driver circuit 120 and the data driver circuit 130 into a single chip.

In one embodiment, the display device 100 may be a bistable display, such as an electrophoretic display (EPD) or a cholesteric liquid crystal (ChLCD) display. Those applying this embodiment may adjust the type of the display device 100 according to their requirements, as long as the pixel units in the display device 100 require high voltage driving, this embodiment may be applied. In one embodiment, the display device 100 is an electronic paper display. Each of the pixel units P(1,1)~P(M,N) may include a display component, such as a microcapsule, a microcup, or a liquid crystal unit.

In one embodiment, the pixel array 110 may be a thin film transistor (TFT) array. Each of the pixel units P(1,1)~P(M,N) includes a pixel circuit. The pixel circuit is formed on a glass substrate. The pixel circuit is used to generate voltage according to at least one gate drive signal and at least one data signal (also referred to as source drive signal) to drive a corresponding display component. In one embodiment, the gate driver circuit 120 includes a plurality of gate drivers, and the plurality of gate drivers are formed on the glass substrate in a gate on array (GOA) manner. The pixel array 110 and the gate driver circuit 120 may be formed on the same glass substrate. In one embodiment, the plurality of gate drivers may be respectively coupled to a plurality of pixel units in different rows.

In one embodiment, the pixel circuits of the pixel units P(1,1)~P(M,N) may include a bootstrap capacitor and a corresponding switching transistor, utilizing a capacitive coupling effect to boost the voltage of a specific node in the pixel circuit, thereby reducing the high voltage specification requirements of the gate driver circuit 120 or the data driver circuit 130. For example, in one embodiment, the pixel circuit may include a gate bootstrap circuit, which boosts the gate voltage of an active matrix switch through the capacitive coupling effect, thereby reducing the requirement of the gate driver circuit 120 for high voltage specifications. In another embodiment, the pixel circuit may include a pixel voltage bootstrap circuit, which further boosts the pixel voltage stored on the pixel capacitor through the capacitive coupling effect after a write operation, thereby reducing the output voltage range requirement of the data driver chip 210. The data multiplexer of the present invention (such as data multiplexers 220-1~220-N/2) may be applicable to pixel circuits adopting the above various bootstrap circuit architectures to ensure that data signals may be smoothly and accurately transmitted to corresponding pixel circuits through multiplexer bootstrap (MUX bootstrap) technology.

Additionally, in the description of the following embodiments, the first terminal and the second terminal of the transistor may be a drain or a source respectively, and the control terminal of the transistor may be a gate, but the present invention is not limited thereto. The polarity of each terminal of the transistor may be determined according to different transistor types.

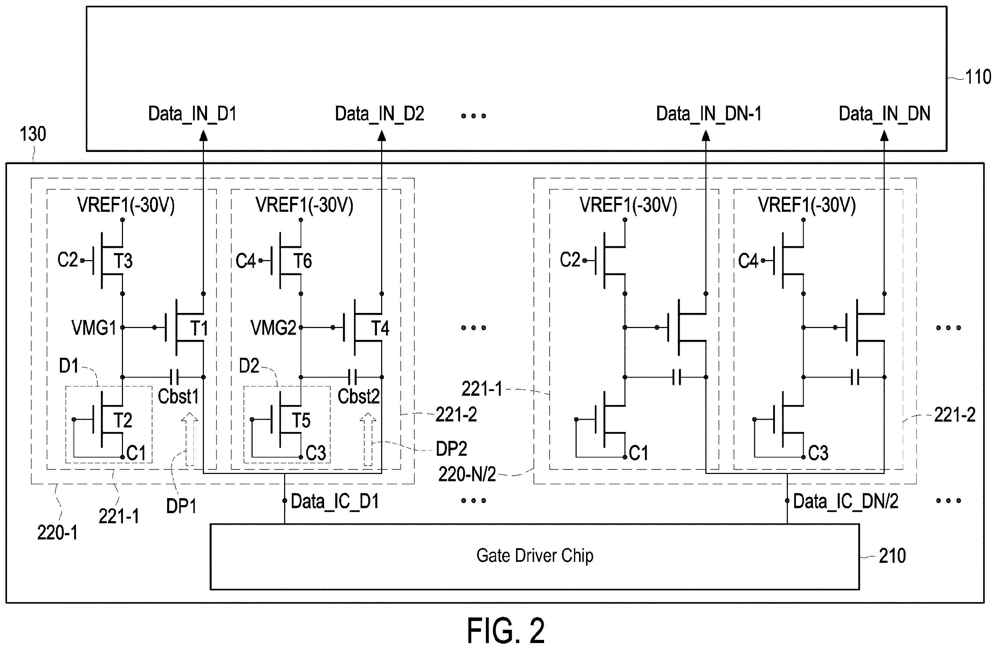

FIG. 2 is a block diagram of the pixel array 110 and the data driver circuit 130 according to an embodiment of the present invention. Referring to FIG. 2, the pixel array 110 includes a plurality of pixel units (not shown) and corresponding plurality of pixel data lines Data_IN_D1~Data_IN_DN. The data driver circuit 130 is coupled to the pixel data lines Data_IN_D1~Data_IN_DN to provide corresponding data signals (data voltages). The data driver circuit 130 includes a data driver chip 210 (also referred to as a source driver chip) and data multiplexers 220-1~220-N/2. The data driver chip 210 includes a plurality of chip data lines Data_IC_D1~Data_IC_DN/2.

In order to reduce the number of pins of the data driver chip 210, this embodiment couples corresponding data multiplexers 220-1~220-N/2 to each chip data line Data_IC_D1~Data_IC_DN/2. Each data multiplexer includes two or more multiplexer circuits. For example, in FIG. 2, each data multiplexer 220-1~220-N/2 includes two data paths DP1~DP2, and each of the data paths DP1~DP2 respectively corresponds to each of the multiplexer circuits 221-1~221-2. That is, in each of the data multiplexers 220-1~220-N/2 of FIG. 2, the quantity of data paths and multiplexer circuits provided is K, where K is a positive integer greater than or equal to 2. Therefore, the quantity of chip data lines is one-Kth of the quantity of pixel data lines. In FIG. 2, the quantity of data paths and multiplexer circuits is 2 (i.e., K equals 2). Those applying this embodiment may adjust the quantity of multiplexer circuits 221-1~221-2 in each data multiplexer 220-1~220-N/2 according to their requirements. For example, each data multiplexer may include three or more multiplexer circuits, that is, K may be a value of 3 or above.

The multiplexer circuit 221-1 includes transistors T1 and T3, a bootstrap capacitor Cbstl, and a diode D1. The first terminal of the transistor T1 is coupled to one of the pixel data lines (e.g., the pixel data line Data_IN_D1). The second terminal of the transistor T1 is coupled to one of the chip data lines (e.g., the chip data line Data_IC_D1). The bootstrap capacitor Cbstl is coupled between the second terminal and the control terminal of the transistor T1. The control terminal of the transistor T1 has a voltage VMG1.

The diode D1 is coupled between the control terminal of the transistor T1 and the control line C1. For example, the anode of the diode D1 is coupled to the control terminal of the transistor T1; the cathode of the diode D1 is coupled to the control line C1 to receive the control signal CS1. The diode D1 includes the transistor T2. The first terminal of the transistor T2 is coupled to the control terminal of the transistor T1. The second terminal of the transistor T2 is coupled to the control terminal of the transistor T2 and is coupled to the control line C1.

The first terminal of the transistor T3 is coupled to the reference voltage terminal VREF1. The second terminal of the transistor T3 is coupled to the control terminal of the transistor T1. The control terminal of the transistor T3 is coupled to the control line C2. The control line C1 is used to transmit the control signal CS1. The control line C2 is used to transmit the control signal CS2. The pulse periods of the control signals CS1 and CS2 respectively do not overlap. The reference voltage on the reference voltage terminal VREF1 in this embodiment is -30V. That is, the reference voltage on the reference voltage terminal VREF1 is equivalent to the low voltage level VGL of the control signals CS1 and CS2.

The multiplexer circuit 221-2 includes transistors T4 and T6, a bootstrap capacitor Cbst2, and a diode D2. The diode D2 includes the transistor T5. The control terminal of the transistor T4 has a voltage VMG2. The multiplexer circuits 221-1 and 221-2 have the same circuit structure.

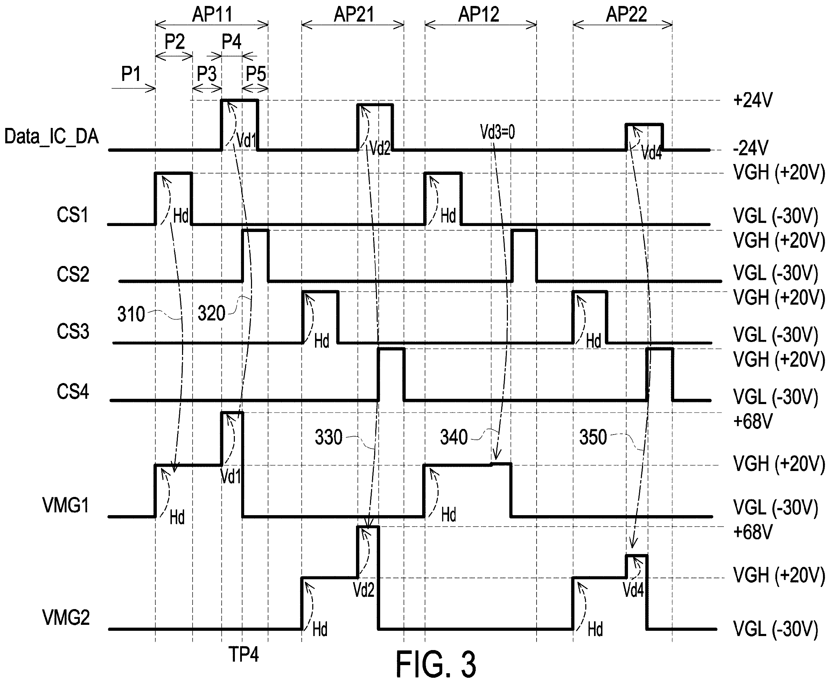

FIG. 3 is a timing diagram of multiple signals and voltages in the data multiplexer of FIG. 2. The multiplexer circuits 221-1 and 221-2 have the same circuit structure, and this embodiment uses the multiplexer circuit 221-1 as an example to illustrate its operation method. The data signal Data_IC_DA on the chip data line in FIG. 3 is used to represent the data signal corresponding to the multiplexer circuits 221-1 and 221-2 in FIG. 3. In this embodiment, the voltage range of the data signal Data_IC_DA is positive and negative 24 volts; the voltage range of the control signals CS1~CS4 on the control lines C1~C4 is between the high voltage level VGH (e.g., positive 20 volts (+20V)) and the low voltage level (e.g., -30V); the voltage range of the voltages VMG1 and VMG2 on the control terminals of the transistors T1 and T4 may be between -30V and +68V.

Referring to FIG. 2 and FIG. 3, the multiplexer circuits 221-1 and 221-2 may generate voltage VMG1 on the control terminal of the transistor T1 and the voltage VMG2 on the control terminal of the transistor T4 by utilizing the control signals CS1~CS4 on the control lines C1~C4 based on the operation method of the embodiment in FIG. 3, so that the operating voltages of the control terminals of the transistors T1 and T4 in the multiplexer circuits 221-1 and 221-2 may be effectively boosted to sufficiently high levels.

In FIG. 3, the time periods AP11 and AP12 are the working time periods of the multiplexer circuit 221-1, and the control signals CS1~CS2 on the control lines C1~C2 will be sequentially enabled; the time periods AP21 and AP22 are the working time periods of the multiplexer circuit 221-2, and the control signals CS3~CS4 on the control lines C3~C4 will be sequentially enabled. Here, the time period P1, the time periods P2~P5 within the time period AP11, and the time point TP4 are used for explanation.

In time period P1, the control signals CS1~CS4 are all disabled (the low voltage level VGL), and the transistors T1, T3 and the diode D1 are all in turn-off state. In the time period P2, the control signal CS1 on the control line C1 is boosted from the low voltage level VGL to the high voltage level VGH. The diode D1 is switched from the turn-off state to the conduction state based on the control signal CS1, so that the voltage VMG1 of the control terminal of the transistor T1 is boosted from the low voltage level VGL to the high voltage level VGH. In other words, based on the control signal CS1 is boosted by the voltage difference Hd from the low voltage level VGL, the voltage VMG1 is also boosted by the voltage difference Hd from the low voltage level VGL, as shown by the dashed arrow 310.

In the time period P3 after the time period P2, the control signal CS1 on the control line C1 is reduced from the high voltage level VGH to the low voltage level VGL, the diode D1 is switched from the conduction state to the turn-off state, and the voltage VMG1 maintains at the high voltage level VGH.

In the time period P4 after the time period P3, one of the chip data lines provides the data voltage (that is, the voltage difference Vd1 on the data signal Data_IC_DA). At this time, since the bootstrap capacitor Cbstl is coupled between the second terminal of the transistor T1 (that is, the data signal Data_IC_DA) and the control terminal of the transistor T1, when the data signal Data_IC_DA is boosted by the data voltage (the voltage difference Vd1), the voltage VMG1 is boosted by data voltage (the voltage difference Vd1) from the high voltage level VGH based on the bootstrap capacitor Cbst1, as shown by the dashed arrow 320. Here it is assumed that the data signal Data_IC_DA in the time period P4 is boosted from -24V to +24V, the voltage difference Vd1 is 48V, therefore the voltage VMG1 is boosted by the voltage difference Vdl (48V) from the high voltage level VGH (+20V) to reach +68V. In this embodiment, the voltage range of the data signal is between positive and negative 24V, therefore the value of the voltage difference Vd1 may be between -24V to positive 24V. That is, the voltage range of the voltages VMG1 and VMG2 on the control terminals of the transistors T1 and T4 may be between -30V to +68V.

At the time point TP4 after the time period P4, the control signal CS2 on the control line C2 is boosted from the low voltage level VGL to the high voltage level VGH, the transistor T3 therefore is switched from the turn-off state to the conduction state, and the voltage VMG1 becomes the same as the reference voltage (such as -30V) on the reference voltage terminal VREF1 based on the transistor T3 being in the conduction state.

In the time period P5, since the control signal CS2 on the control line C2 is at the high voltage level VGH, the transistor T3 is in the conduction state. Therefore, even if the data signal Data_IC_DA has the data voltage (the voltage difference Vd1), the voltage VMG1 still remains the same as the reference voltage (such as -30V) on the reference voltage terminal VREF1. The time periods P2~P5 of the time period AP11 may effectively boost the working voltage of the control terminal of the transistor T1 in the multiplexer circuit 221-1 to sufficiently high, thereby ensuring that data signals with the voltage range of positive and negative 24 volts may be smoothly and accurately transmitted to each pixel unit in the pixel array.

In the time periods AP21 and AP22, similar to the operation method of the time period AP11, the control signals CS3~CS4 on the control lines C3~C4 will be sequentially enabled, causing the voltage VMG2 to gradually boost from the low voltage level VGL to the high voltage level VGH, and then boost from the high voltage level VGH by the data voltage (the voltage differences Vd2 and Vd4), as shown by the dashed arrows 330 and 350. In this way, the working voltage of the control terminal of the transistor T4 in the multiplexer circuit 221-2 of FIG. 2 is effectively boosted to sufficiently high, thereby ensuring that data signals with voltage range of positive and negative 24 volts may be smoothly and accurately transmitted to each pixel unit in the pixel array.

In the time period AP12, similar to the operation method of the time period AP11, the control signals CS1~CS2 on the control lines C1~C2 will be sequentially enabled, causing the voltage VMG1 to gradually boost from the low voltage level VGL to the high voltage level VGH, and then boost from the high voltage level VGH by the data voltage (the voltage difference Vd3), as shown by the dashed arrow 340. In this way, although the voltage difference Vd3 is 0, the working voltage of the control terminal of the transistor T1 in the multiplexer circuit 221-1 of FIG. 2 may still be effectively boosted to sufficiently high, thereby ensuring that data signals with the voltage range of positive and negative 24 volts may be smoothly and accurately transmitted to each pixel unit in the pixel array.

In this embodiment, during the working time period of the multiplexer circuit 221-1 (such as the time period AP11), the corresponding operations of the aforementioned time period P1 to the time point TP4 are performed on the multiplexer circuit 221-1. And, during the working time period of the multiplexer circuit 221-2 (such as the time period AP21), the corresponding operations of the aforementioned time period P1 to the time point TP4 are performed on the multiplexer circuit 221-2. The working time periods of the multiplexer circuit 221-1 (such as the time periods AP11, AP12) and the working time periods of the multiplexer circuit 221-2 (such as the time periods AP21, AP22) are performed alternately with each other.

In one embodiment, the data multiplexers 220-1~220-N/2 of the present invention may be combined with gate bootstrap circuits and applied to the same display device 100. The gate bootstrap circuits are disposed in the pixel circuits of each pixel unit, and boost the gate voltage for controlling active matrix switches through capacitive coupling, enabling the drive voltage specification of the gate driver circuit 120 to be reduced (for example, from approximately 80 volts to approximately 50 volts). The data multiplexers 220-1~220-N/2, through the bootstrap capacitors (such as Cbst1, Cbst2) of each multiplexer circuit (such as the multiplexer circuits 221-1, 221-2), boost the voltages of the control terminals of the first transistors T1, T4 to sufficiently high (for example, up to positive 68 volts at maximum), ensuring that data signals may be smoothly written into pixel circuits employing gate bootstrap circuits. In other words, the Data MUX Bootstrap technology and the Gate Bootstrap technology within pixels each operate independently in different subsystems, respectively reducing the high voltage specification requirements of the data driver chip 210 and the gate driver circuit 120, with neither interfering with the other and their benefits being additive, jointly achieving the comprehensive voltage reduction goal of the display system.

In another embodiment, the data multiplexers 220-1~220-N/2 of the present invention may be combined with pixel voltage bootstrap circuits and applied to the same display device 100. The pixel voltage bootstrap circuits are disposed in the pixel circuits of each pixel unit, utilizing one or more bootstrap capacitors to perform one or multiple boosts or reductions on the pixel voltage stored in the pixel capacitor through capacitive coupling after data signal writing, making the absolute value of the final pixel voltage higher than the data signal voltage directly output by the data driver chip 210. Under this architecture, the data multiplexers 220-1~220-N/2 ensure that data signals (such as data signal Data_IC_DA with a voltage range of positive and negative 24 volts) may be accurately transmitted to the pixel data lines of each pixel unit through the bootstrap voltage boosting technology of each multiplexer circuit; the pixel voltage bootstrap circuits subsequently further boost the received pixel voltage within the pixel circuit to drive display elements (such as electrophoretic display elements). The bootstrap voltage boosting technology of the data multiplexers and the pixel voltage bootstrap technology form a cascaded voltage boosting chain, respectively solving the high voltage problems in the data transmission path and pixel storage voltage, jointly reducing the system's dependence on high voltage processes.

In yet another embodiment, the pixel circuit may adopt a dual data signal line architecture, including a first transistor and a second transistor, wherein a first terminal of the first transistor is coupled to a first data signal line to receive a first data signal, a first terminal of the second transistor is coupled to a second data signal line to receive a second data signal, and the two data signal lines each independently transmit data signals of different voltage levels. In this pixel circuit architecture, the first data signal line and the second data signal line may respectively correspond to output terminals of two independent multiplexer circuits (such as respectively corresponding to the multiplexer circuit 221-1 and the multiplexer circuit 221-2). Each multiplexer circuit is respectively responsible for the bootstrap voltage boosting transmission of its corresponding data signal line, ensuring that both the first data signal and the second data signal may be accurately written into the pixel circuit with sufficient voltage levels. Under this configuration, the pixel voltage is provided with initial charging by the first data signal, and then through a bootstrap capacitor coupled between the first node and the second node, utilizing the voltage difference generated by the second data signal charging the second node, the pixel voltage of the first node is further substantially boosted from the first voltage to the third voltage (wherein the third voltage is substantially equal to the sum of the first voltage and the second voltage). The bootstrap voltage boosting technology of the data multiplexer ensures that the first data signal and the second data signal are not reduced due to multiplexer transmission loss during transmission, thereby ensuring the correctness of the final pixel voltage.

In one embodiment, the gate driver circuit 120 may adopt a Gate-on-Array (GOA) architecture, wherein at least one stage of the multi-stage gate drivers has a main output terminal (for outputting a first gate drive signal) and a boost output terminal (for outputting a second gate drive signal), and the gate driver having the boost output terminal shares a control circuit with gate drivers belonging to main output terminals of at least one adjacent stage. This configuration enables N-stage gate drivers to generate 2N gate drive signals to drive N rows of pixel units, effectively solving the area problem of gate driver stage multiplication under the bootstrap pixel architecture. Under this architecture, the data multiplexers 220-1~220-N/2 and the gate driver array circuit respectively perform their respective functions on the data side and gate side: the data multiplexers ensure correct data signal transmission through bootstrap voltage boosting; the gate driver array circuit efficiently generates the required multiple sets of gate drive signals through shared control circuits, and both together constitute a low-cost, low-power system-level driving solution suitable for bootstrap pixel circuits.

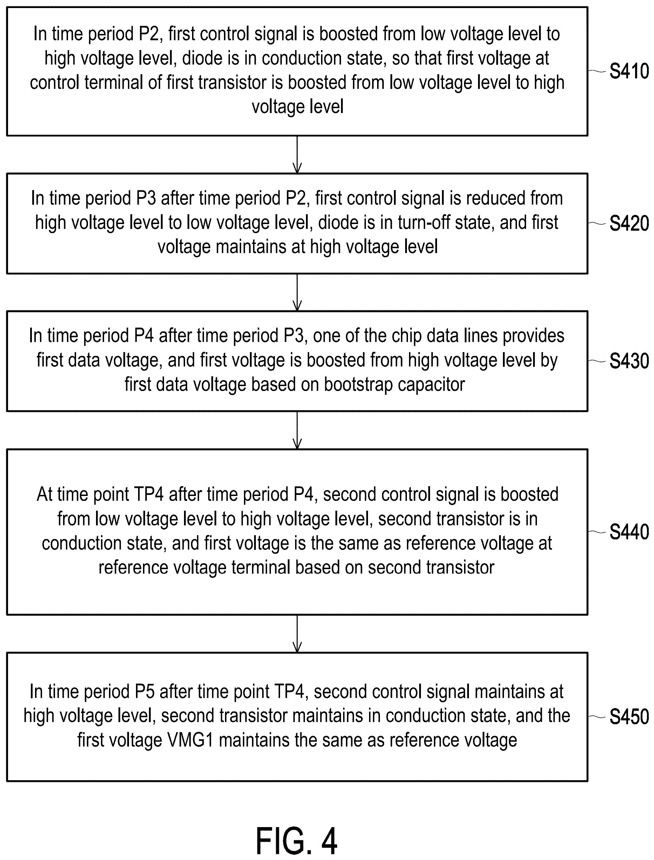

FIG. 4 is a flowchart of a driving method for a display device according to an embodiment of the present invention. The driving method of FIG. 4 is applicable to the display device 100 of FIG. 1. The display device 100 includes a pixel array 110 and a data driver circuit 130. The pixel array 110 includes a plurality of pixel data lines Data_IN_D1~Data_IN_DN. The data driver circuit 130 includes a data driver chip 210 and a plurality of multiplexer circuits 221-1~221-2. The data driver chip 210 includes a plurality of chip data lines Data_IC_D1~Data_IC_DN/2. The circuits in each multiplexer circuit are the same. Taking the multiplexer circuit 221-1 as an example, the multiplexer circuit 221-1 includes the transistor T1, the bootstrap capacitor Cbstl, the diode D1, and the transistor T3. A first terminal of the transistor T1 is coupled to one of the pixel data lines, and a second terminal of the transistor T1 is coupled to one of the chip data lines. The bootstrap capacitor Cbst1 is coupled between the second terminal of the transistor T1 and a control terminal of the transistor T1. The diode D1 is coupled between the control terminal of the transistor T1 and the control line C1. A first terminal of the transistor T3 is coupled to the reference voltage terminal VREF1. A second terminal of the transistor T3 is coupled to the control terminal of the transistor T1. A control terminal of the transistor T3 is coupled to the control line C2. The control signal CS1 is transmitted through the control line C1 and the control signal CS2 is transmitted through the control line C2.

Referring to FIG. 4, taking the multiplexer circuit 221-1 and its working time period (e.g., the time period AP11) as an example, in the time period P1, the control signals CS1~CS4 are all disabled (low voltage level VGL), and the transistor T1, T3, and the diode D1 are all in the turn-off state. In step S410, in the time period P2, the control signal CS1 is boosted from the low voltage level VGL to the high voltage level VGH, the diode D1 is in the conduction state, so that the voltage VMG1 at the control terminal of the transistor T1 is boosted from the low voltage level VGL to the high voltage level VGH. In step S420, in the time period P3 after the time period P2, the control signal CS1 is reduced from the high voltage level VGH to the low voltage level VGL, the diode D1 is in the turn-off state, and the voltage VMG1 maintains at the high voltage level VGH. In step S430, in the time period P4 after the time period P3, one of the chip data lines (e.g., the chip data line Data_IC_DA) provides the data voltage (the voltage difference Vd1), and the voltage VMG1 is boosted from the high voltage level VGH by the data voltage (the voltage difference Vd1) based on the bootstrap capacitor Cbstl. In step S440, at the time point TP4 after the time period P4, the control signal CS2 is boosted from the low voltage level VGL to the high voltage level VGH, the transistor T3 is in the conduction state, and the voltage VMG1 is the same as the reference voltage at the reference voltage terminal VREF1 based on the transistor T3. In step S450, in the time period P5 after the time point TP4, the control signal CS2 maintains at the high voltage level VGH, the transistor T3 maintains in the conduction state, and the voltage VMG1 maintains the same as the reference voltage. Each multiplexer circuit may execute the aforementioned steps S410 to S450. For relevant details of each step in FIG. 4, please refer to the aforementioned embodiments.

In summary, the display device and driving method thereof according to various embodiments of the present invention additionally provide two transistors and a bootstrap capacitor in each multiplexer circuit in the data multiplexer, and enable the working voltage of the control terminal of the first transistor in the multiplexer circuit to be effectively boosted to sufficiently high (e.g., up to positive 68 volts at maximum), thereby ensuring that data signals with a voltage range of positive and negative 24 volts may be smoothly and accurately transmitted to each pixel unit in the pixel array. Based on the bootstrap capacitor and the voltage bootstrap technology in this data multiplexer, the demand for high voltage processes may be significantly reduced without requiring high voltage drive systems (e.g., boost converters), thereby reducing manufacturing costs.

## Claims

1. A display device (100), comprising:
a pixel array (110), comprising a plurality of pixel data lines (Data_IN_D1~Data_IN_DN); and
a data driver circuit (130), coupled to the pixel data lines (Data_IN_D1~Data_IN_DN),
wherein the data driver circuit (130) comprises:
a data driver chip (210), comprising a plurality of chip data lines (Data_IC_D1~Data_IC_DN/2); and
a data multiplexer (220-1~220-N/2), comprising a plurality of multiplexer circuits (221-1~221-2),
wherein each of the multiplexer circuits (221-1~221-2) comprises:
a first transistor (T1, T4), a first terminal of the first transistor (T1, T4) coupled to one of the pixel data lines (Data_IN_D1~Data_IN_DN), a second terminal of the first transistor (T1, T4) coupled to one of the chip data lines (Data_IC_D1~Data_IC_DN/2);
a bootstrap capacitor (Cbst1, Cbst2), coupled between the second terminal of the first transistor (T1, T4) and a control terminal of the first transistor (T1, T4);
a diode (D1, D2), coupled between the control terminal of the first transistor (T1, T4) and a first control line (C1); and
a second transistor (T3, T6), a first terminal of the second transistor (T3, T6) coupled to a reference voltage terminal (VREF1), a second terminal of the second transistor (T3, T6) coupled to the control terminal of the first transistor (T1, T4), a control terminal of the second transistor (T3, T6) coupled to a second control line (C2, C4).

2. The display device (100) as recited in claim 1, wherein the data multiplexer (220-1~220-N/2) comprises a plurality of data paths (DP1, DP2), each of the data paths (DP1, DP2) corresponding to a respective one of the multiplexer circuits (221-1~221-2).

3. The display device (100) as recited in claim 2, wherein the quantity of the data paths (DP1, DP2) and the multiplexer circuits (221-1~221-2) is 2.

4. The display device (100) as recited in claim 1, wherein the diode (D1, D2) comprises a third transistor (T2, T5),
a first terminal of the third transistor (T2, T5) is coupled to the control terminal of the first transistor (T1, T4), a second terminal of the third transistor (T2, T5) is coupled to a control terminal of the third transistor (T2, T5) and is coupled to the first control line (C1).

5. The display device (100) as recited in claim 1, wherein the first control line (C1) is configured to transmit a first control signal (CS1), the second control line (C2) is configured to transmit a second control signal (CS2),
wherein pulse periods of the first control signal (CS1) and the second control signal (CS2) respectively do not overlap.

6. The display device (100) as recited in claim 5, wherein in a first time period (P2), the first control signal (CS1) is boosted from a low voltage level (VGL) to a high voltage level (VGH), the diode (D1, D2) is in a conduction state, so that a first voltage of the control terminal of the first transistor (T1, T4) is boosted from the low voltage level (VLGL) to the high voltage level (VGH).

7. The display device (100) as recited in claim 6, wherein in a second time period (P3) after the first time period (P2), the first control signal (CS1, CS3) is reduced from the high voltage level (VGH) to the low voltage level (VGL), the diode (D1, D2) is in a turn-off state, the first voltage (VMG1, VMG2) is maintained at the high voltage level (VGH).

8. The display device (100) as recited in claim 7, wherein in a third time period (P4) after the second time period (P3), the one of the chip data lines (Data_IC_D1~Data_IC_DN/2) provides a first data voltage (Vd1), the first voltage (VMG1, VMG2) is boosted from the high voltage level (VGH) by the first data voltage (Vd1) based on the bootstrap capacitor (Cbstl, Cbst2).

9. The display device (100) as recited in claim 8, wherein at a fourth time point (TP4) after the third time period (P4), the second control signal (CS2, CS4) is boosted from the low voltage level (VGL) to the high voltage level (VGH), the second transistor (T3, T6) is in a conduction state, and the first voltage (VMG1, VMG2) is the same as a reference voltage on the reference voltage terminal (VREF1) based on the second transistor (T3, T6).

10. The display device (100) as recited in claim 9, wherein the reference voltage is equivalent to the low voltage level (VGL).

11. The display device (100) as recited in claim 10, wherein the low voltage level (VGL) is negative 30 volts, the high voltage level (VGH) is positive 20 volts.

12. The display device (100) as recited in claim 1, wherein the display device (100) is a bistable display.

13. The display device (100) as recited in claim 12, wherein the bistable display is an electrophoretic display, a voltage range of data signals on the chip data lines (Data_IC_D1~Data_IC_DN/2) is positive and negative 24 volts, a voltage range of a first voltage (VMG1, VMG2) on the control terminal (VMG1, VMG2) of the first transistor (T1, T4) is between negative 30 volts to positive 68 volts.

14. The display device (100) as recited in claim 2, wherein a quantity of the data paths (DP1, DP2) and the multiplexer circuits (221-1~221-2) is K, K being a positive integer greater than or equal to 2.

15. The display device (100) as recited in claim 14, wherein a quantity of the chip data lines (Data_IC_D1~Data_IC_DN/2) is one Kth of a quantity of the pixel data lines (Data_IN_D1~Data_IN_DN).

16. A driving method for a display device (100), the display device (100) comprising a pixel array (110) and a data driver circuit (130), the pixel array (110) comprising a plurality of pixel data lines (Data_IN_D1~Data_IN_DN), the data driver circuit (130) comprising a data driver chip (210) and a plurality of multiplexer circuits (221-1~221-2), the data driver chip (210) comprising a plurality of chip data lines (Data_IC_D1∼Data_IC_DN/2), each of the multiplexer circuits (221-1~221-2) comprising a first transistor (T1, T4), a bootstrap capacitor (Cbst1, Cbst2), a diode (D1, D2) and a second transistor (T3, T6), a first terminal of the first transistor (T1, T4) being coupled to one of the pixel data lines (Data_IN_D1~Data_IN_DN), a second terminal of the first transistor (T1, T4) being coupled to one of the chip data lines (Data_IC_D1~Data_IC_DN/2), the bootstrap capacitor (Cbstl, Cbst2) being coupled between the second terminal of the first transistor (T1, T4) and a control terminal of the first transistor (T1, T4), the diode (D1, D2) being coupled between the control terminal of the first transistor (T1, T4) and a first control line (C1), a first terminal of the second transistor (T3, T6) being coupled to a reference voltage terminal (VREF1), a second terminal of the second transistor (T3, T6) being coupled to the control terminal of the first transistor (T1, T4), a control terminal of the second transistor (T3, T6) being coupled to a second control line (C2, C4), a first control signal (CS1, CS3) being transmitted through the first control line (C1, C3) and a second control signal (CS2, CS4) being transmitted through the second control line (C2, C4),
the driving method comprising:
(S410) in a first time period (P2), the first control signal (CS1, CS3) is boosted from a low voltage level (VGL) to a high voltage level (CGH), the diode (D1, D2) is in a conduction state, so that a first voltage (VMG1, VMG2) of the control terminal of the first transistor (T1, T4) is boosted from the low voltage level (VGL) to the high voltage level (VGH);
in a second time period (P3) after the first time period (P2), the first control signal (CS1, CS3) is reduced from the high voltage level (VGH) to the low voltage level (VGL), the diode (D1, D2) is in a turn-off state, the first voltage (VMG1, VMG2) is maintained at the high voltage level (VGH);
in a third time period (P4) after the second time period (P3), the one of the chip data lines (Data_IC_D1~Data_IC_DN/2) provides a first data voltage (Vd1, Vd2), the first voltage (VMG1, VMG2) is boosted from the high voltage level (VGH) by the first data voltage (Vd1, Vd2) based on the bootstrap capacitor (Cbstl, Cbst2); and
at a fourth time point (TP4) after the third time period (P4), the second control signal (CS2) is boosted from the low voltage level (VGL) to the high voltage level (VGH), the second transistor (T3, T6) is in a conduction state, and the first voltage (VMG1, VMG2) is the same as a reference voltage on the reference voltage terminal (VREF1) based on the second transistor (T3, T6).

17. The driving method as recited in claim 16, wherein the multiplexer circuits (221-1~221-2) comprise a first multiplexer circuit (221-1) and a second multiplexer circuit (221-2), the driving method further comprising:
in a first work time period (AP11, AP12) of the first multiplexer circuit (221-1), performing the first time period (P2) to the fourth time point (TP4) on the first multiplexer circuit (221-1); and
in a second work time period (AP21, AP22) of the second multiplexer circuit (221-2), performing the first time period (P2) to the fourth time point (TP4) on the second multiplexer circuit (221-2),
wherein the first work time period (AP11, AP12) and the second work time period (AP21, AP22) are performed alternately.

18. The driving method as recited in claim 16, wherein the reference voltage on the reference voltage terminal (VREF1) is equivalent to the low voltage level.

19. The driving method as recited in claim 18, wherein the low voltage level (VGL) is negative 30 volts, the high voltage level (VGH) is positive 20 volts.

20. The driving method as recited in claim 16, wherein the display device (100) is an electrophoretic display, a voltage range of the first data voltage (Vd1~Vd4) is positive and negative 24 volts, a voltage range of the first voltage (VMG1, VMG2) after being boosted from the high voltage level (VGH) is between negative 30 volts to positive 68 volts.

21. The driving method as recited in claim 16, wherein in a fifth time period (P5) after the fourth time point (TP4), the second control signal (CS2, CS4) is maintained at the high voltage level (VGH), the second transistor (T3, T6) is maintained in the conduction state, the first voltage (VMG1, VMG2) is maintained the same as the reference voltage.
